# EUROPEAN PATENT SPECIFICATION

(11) **EP 2 694 602 B1**
(45) Date of publication and mention of the grant of the patent: **06.07.2016**
(21) Application number: 12711188.8
(22) Date of filing: 30.03.2012
(51) Int. Cl.: C09D 11/00

(54) **RADIATION CURABLE COMPOSITIONS**
STRAHLUNGSHÄRTBARE ZUSAMMENSETZUNGEN
COMPOSITIONS DURCISSABLES PAR RAYONNEMENT

(30) Priority: 05.04.2011 EP 11161137
(43) Date of publication of application: 12.02.2014
(73) Proprietor: Allnex Belgium, S.A., 1070 Brussels (BE)
(72) Inventor: VAN DEN BERGEN, Hugues, B-1620 Drogenbos (BE); GEVAERT, Paul, B-9500 Geraardsbergen (BE); DE WAELE, Luc, B-9400 Denderwindeke (BE); LINDEKENS, Luc, B-1785 Merchtem (BE)
(74) Representative: Schoofs, Hilde
(86) International application number: PCT/EP2012/055818
(87) International publication number: WO 2012/136588

(56) References cited:
- EP-A1- 1 762 600
- WO-A1-01/25288
- WO-A1-01/27181
- WO-A1-03/078512
- WO-A1-2009/115489
- DE-A1-102007 034 865

## Description

The present invention relates to radiation curable compositions comprising inert resins that are suitable for use on various substrates, including plastic substrates; to their preparation and their uses.

Commercially available UV flexographic inks have limited adhesion on flexible plastic substrates. Especially adhesion on plastic substrates without adhesion primer is poor.

It is theoretically possible to increase adhesion on plastics by using "inert" resins diluted in monomers, but hereby the UV reactivity often significantly decreases. WO2008/015474 & WO2008/004002 disclose printing inks with inert resins dissolved in e.g.
tetrahydrofurfurylacrylate, N-vinyl caprolactam and phenoxyethyl acrylate. The inks disclosed herein are not suited for flexographic applications and/or for use in food-packaging due to a too low UV reactivity and migration of uncured monomers.

The UV reactivity can be increased by adding multifunctional acrylates, but this has a negative impact on adhesion due to shrinkage increase after curing.

For that reason, an adhesion primer is currently applied on the plastic substrate to increase adhesion before applying the UV curable flexographic ink.

There is thus a need for radiation curable inks binders with improved adhesion to plastic substrates and advantageously an acceptable UV reactivity, good pigment wetting properties and medium viscosity. If no primer is needed, the application process is easier and/or more cost effective.

The UV curable ink binders and inks of the present invention provide a solution to one or more of the above problems.

Against this background we now provide a radiation curable composition comprising at least one ethylenically unsaturated compound (A) and at least one inert OH-terminated polyester (B) prepared from (i) a polyol component that comprises ethylene glycol (also known as ethane-1,2-diol), and from (ii) a polycarboxy component that comprises phthalic acid and/or phthalic anhydride or that comprises one or more dialkylesters of phthalic acid; wherein the inert polyester (B) has a total equivalent ratio of hydroxyl groups from the polyols to carboxyl groups from the polycarboxylic acids that exceeds 1.0 so that the said inert polyester (B) has free hydroxyl groups on the ends of the polymer backbone; and wherein the inert polyester (B) has 0.1 or fewer equivalents of radiation curable reactive groups per kilogram.

The inert polyester (B) can be obtained via an esterificiation or via a transesterification reaction. When prepared via transesterification, the polycarboxylic acid is substituted by a polycarboxylic acid dialkyl ester, in casu a phthalic acid dialkylester. In general the alkyl chains of this ester have from 1 to 20, preferably from 1 to 8, more preferably from 1 to 4 carbon atoms. Dimethylesters and/or diethylesters are usually preferred. Preferably however the inert polyester (B) is obtained via an esterificiation reaction.

Preferred are hence radiation curable compositions comprising at least one ethylenically unsaturated compound (A) and at least one inert OH-terminated polyester (B) prepared from (i) a polyol component that comprises ethylene glycol, and from (ii) a polycarboxy component that comprises phthalic acid and/or phthalic anhydride. Phthalic anhydride is preferred.

By an "inert polyester" is meant a polyester that does not take part in the polymerization process. Such polyesters contain few or no curable reactive groups. "Curable reactive groups" are those capable of participating in the cure reaction that takes place when the radiation curable composition of the present invention is exposed to energy radiation, such as UV radiation, electron beam and/or actinic radiation. Due to imperfections in manufacture or to degradation on storage, polyesters that are considered essentially free of reactive groups may actually have a small number of reactive groups. Typically the polyesters of the invention have 0.1 or fewer equivalents of curable reactive groups per kilogram; more preferred is 0.01 or fewer; even more preferred is 0.003 or fewer; still more preferred is 0.001 or fewer, and most preferred is none. Some common reactive groups that are used in radiation curable compositions are double bonds in the form of e.g. (meth)acrylic groups and/or vinyl groups. Consequently, polyesters containing (meth)acrylic and/or vinyl groups in large amounts do not qualify as inert polyesters in the present invention. However, double bonds contained in aromatic rings are known to generally be inert during radiation curing. By "(meth)acrylic groups" is meant acrylic groups, methacrylic groups, and mixtures thereof.

Inert polyesters (B) that are used in the present invention can be produced in any way known in the art. They typically are prepared from the polycondensation of at least one polyol with at least one polycarboxylic acid, and, optionally, from one or more mono-carboxylic compounds (see X1 infra). Typically, the polyols and the polycarboxylic acids used are saturated compounds, though some aromatic substructures may be present. Double bonds contained in aromatic rings are known to generally be inert during radiation curing (see above).

"Polyols" are compounds with two or more hydroxyl groups on each molecule. Preferred polyols are diols (i.e., polyols with two hydroxyl groups per molecule).

Besides ethylene glycol, the polyol component used to prepare the polyester may, optionally, also comprise one or more other suitable polyols. By "other polyols" is meant a polyol different from ethylene glycol.

Preferably the polyol component used to prepare the polyester comprises from 10 to 100 mole% of ethylene glycol, and, optionally, from 0 to 90 mole% of other suitable polyols such as neopentyl glycol (2,2-Dimethyl-1,3-propanediol); diethylene glycol; propyleneglycol; dipropyleneglycol; triethyleneglycol; 2-methyl-1,3-propanediol (MPD); 2-ethyl-2-butyl-1,3-propanediol; 1-ethyl-2-methyl-1,3-propanediol; 2-ethyl-2-methyl-1,3-propanediol; 1,3-butylene glycol; 1,4-butanediol; 2,3-butanediol; 2-butyl-2-ethyl-1,3-propanediol (BEPD); pentanediol; 2-methyl 2-ethyl- 1,3-propane diol; 1,3-pentane diol; 2,2,4-trimethyl-1,3-pentane diol; hexyleneglycol; 1,6-hexanediol; 1,4-cyclohexanediol; 1,4-cyclohexanedimethanol; 3-hydroxy-2,2-dimethyl propyl-3-hydroxy-2,2-dimethyl-propanoate (hydroxylpivalyl hydroxypivalate (HPHP); hydroxypivalate of neopentyl glycol); 2,2,4-trimethyl-1,3-pentanediol (TMPD); hydrogenated Bisphenol A; a dianhydrohexitol (like isosorbide, isomannide and/or isoidide); 3(4),8(9)-bis-(hydroxymethyl)-tricyclo-[5.2.1.0^{2,6}]decane; and mixtures thereof (of any of these). Preferred amongst those "other suitable polyols" are neopentyl glycol; propyleneglycol; 2-methyl-1,3-propanediol (MPD); 2-ethyl, 2-butyl-1,3-propanediol; 1-ethyl-2-methyl-1,3-propanediol; 2-ethyl-2-methyl-1,3-propanediol; 1,3-butylene glycol; 1,4-butanediol; 2,3-butanediol; 2-butyl-2-ethyl-1,3-propanediol (BEPD); 2-methyl-2-ethyl-1,3-propane diol; 1,4-cyclohexanediol; 1,4-cyclohexanedimethanol; 3-hydroxy-2,2-dimethyl propyl 3-hydroxy-2,2-dimethyl-propanoate; hydrogenated Bisphenol A; a dianhydrohexitol (like isosorbide, isomannide and/or isoidide); and mixtures thereof. Even more preferred are neopentyl glycol, hydrogenated Bisphenol A, dianhydrohexitols (in particular isosorbide), and mixtures thereof. Most preferred are neopentyl glycol, hydrogenated Bisphenol A, and mixtures thereof; and in particular neopentyl glycol. Surprisingly, neopentyl glycol was found to improve adhesion on plastic substrates. Surprisingly, isosorbide showed improved adhesion on polyethylene terephthalate (PET) substrates.

Typically the polyol component comprises no polyalkylene glycol with a molecular weight (MW) higher than 1000 Daltons. Examples of polyalkylene glycols are polyethylene glycol and/or polypropylene glycol. By "polyethylene glycol" is meant to designate an OH-functionalized polymer based on ethyleneglycolether-units with a MW higher than 1000 Daltons. By "polypropylene glycol" is meant to designate an OH-functionalized polymer based on propyleneglycolether-units with a MW higher than 1000 Daltons.

"Polycarboxylic acids" are compounds with two or more carboxylic acid groups on each molecule. Preferred polycarboxylic acids are diacids (i.e., polycarboxylic acids with two carboxylic acid groups per molecule).

In the practice of the present invention, the polycarboxylic acid may be an anhydride, or it can be a suitable corresponding dialkylester of the polycarboxylic acid. Dialkylesters like dimethylesters and/or diethylesters are preferred.

In an embodiment of the invention the polycarboxy component used to prepare the polyester comprises phthalic acid and/or phthalic anhydride; and, optionally, one or more other suitable polycarboxylic acids. Typically the polycarboxy component comprises from 80 to 100 mole% of phthalic acid and/or phthalic anhydride; and, optionally, from 0 to 20 mole% of other suitable polycarboxylic acids. By "other polycarboxylic acids" is then meant polycarboxylic acids different from phthalic acid and from phthalic anhydride.

In a preferred embodiment of the invention the polycarboxy component comprises from 80 to 100 mole% of phthalic anhydride, optionally, from 0 to 20 mole% of other suitable polycarboxylic acids (ii'). By "other polycarboxylic acids" is then meant polycarboxylic acids different from phthalic anhydride.

Examples of "other suitable polycarboxylic acids" that may be used include chlorendic acid; chlorendic anhydride; adipic acid; oxalic acid; glutaric acid; malonic acid; butanedioic acid; glutaric acid; 1,4-cyclohexane dicarboxylic acid (CHDA); 1,4-cyclohexane dimethylcarboxylic acid; and mixtures thereof. Also terephthalic acid and/or isophthalic acid may be used. Particulary suited are: adipic acid; oxalic acid; glutaric acid; malonic acid; butanedioic acid; glutaric acid; 1,4-cyclohexane dicarboxylic acid; 1,4-cyclohexane dimethylcarboxylic acid; and mixtures thereof. Preferred are isophtalic acid; terephtalic acid; oxalic acid; malonic acid; and mixtures thereof. Also these compounds may be provided under the form of a corresponding dialkyl ester, with dimethylesters and diethylesters being preferred.

Preferably, the other suitable polycarboxylic acids used to prepare the polyester contain less than 20 mole% of terephthalic acid and/or isophthalic acid, more preferably less than 15 mole%, typically less than 5 mole% of terephthalic acid and/or isophthalic acid. In a particular embodiment of the invention no terephthalic or isophthalic acid is used.

In general the other suitable polycarboxylic acids (ii') used to prepare the polyester are saturated polycarboxylic acids. Low amounts of unsaturated polycarboxylic acids like alpha, beta-unsaturated acids may be tolerated. Preferably, the polycarboxy component used to prepare the polyester contain less than 5 mole%, more preferably less than 2 mole%, typically less than 1 mole% of alpha, beta-unsaturated acids such as citraconic acid, fumaric acid, itaconic acid, maleic acid and/or mesaconic acids, their corresponding anhydrides, methyl and/or ethyl esters. Typically however no alpha, beta-unsaturated acids are used.

Though tri- and higher functionalized poly-carboxylic compounds could in principle be used, they are less suited in the framework of the present invention.

Preferred are inert polyesters prepared from phthalic anhydride and/or phthalic acid; from ethylene glycol; and, optionally, from neopentyl glycol and/or a dianhydrohexitol (like isosorbide).

Preferred are inert polyesters prepared from phthalic anhydride, from ethylene glycol and, optionally, from neopentyl glycol. These building units preferably constitute the polyol and polycarboxylic acid components used. Mono-carboxylic compounds (X1) are optional further building units (see the polyesters B2 infra).

Highly suitable are also inert polyesters prepared from phthalic anhydride, from ethylene glycol and, optionally, from a dianhydrohexitol (like isosorbide). These building units preferably constitute the polyol and polycarboxylic acid components used. Mono-carboxylic compounds (X1) are optional further building units (see the polyesters B2 infra).

By an "OH-terminated polyester" in the present invention is meant an inert polyester prepared from mixtures of at least one polyol and at least one polycarboxylic acid as given above (any of the embodiments), wherein the total equivalent ratio of hydroxyl groups from the polyols to carboxyl groups from the polycarboxylic acids exceeds 1.0. Preferred are mixtures wherein this ratio exceeds 1.02; more in particular exceeds 1.04. A molar excess of hydroxyl groups will result in polyesters that have free hydroxyl groups attached to the polymer backbone, in particular on the ends of the polymer backbone. By "free hydroxyl" is meant herein hydroxyl groups that have not reacted with carboxyl groups or other moieties to form new covalent bonds. Preferred OH-terminated polyesters are those that have a hydroxyl number of between 50 and 120 mg KOH/g. Preferably the hydroxyl number is at least 60 mg KOH/g, more preferably at least 70mg KOH/g. Preferably the hydroxyl number does not exceed 110 mg KOH/g, more preferably does not exceed 100 mg KOH/g.

Preferably the acid number is at most 25 mg KOH/g, more preferably at most 15 mg KOH/g, even more preferably at most 7 mg KOH/g.

The above polyesters, optionally, can be capped or functionalized through reaction with one or more mono-carboxylic compounds (X1).

According to a first variant of the invention, the inert polyester is not capped or functionalized. The inert polyesters of this first variant of the invention are further referred to as the inert polyesters (B1).

According to a second variant of the invention the inert polyester is further reacted with one or more of these mono-carboxylic compounds (X1). The resulting polyesters are further referred to as the inert polyesters (B2).

The inert polyesters (B2) of this second variant can be prepared in basically 2 different ways. Either an OH- terminated is first prepared, which is then further reacted with one or more mono-carboxylic compounds (X1), or all ingredients are mixed to react in a one-pot system. Examples of suitable mono-carboxylic compounds (X1) that can be used are monocarboxy-substituted moieties having photo-initiating activity. Preferred are photo-initiators of the carboxylic substituted benzophenone-type. Examples of such compounds are 2-(4-chlorobenzoyl) benzoic acid (Chloro-AOBB), o-benzoylbenzoic acid (o-BBA), o-(p-dimethylaminobenzoyl) benzoic acid, o-(p-diethylaminobenzoyl) benzoic acid etc. as described in e.g. US4028204. Also suitable is 2-(4-phenylbenzoyl)benzoic acid. Another example of a mono-carboxylic compound without photo-initiating properties that can be used is benzoic acid and substituted benzoic acid, or any combination thereof. Examples of substituted benzoic acid include tert-butyl benzoic acid (such as 4-tert-Butylbenzoic acid, 3-tert-Butylbenzoic acid, or 2-tert-Butylbenzoic acid), naphthalene carboxylic acid, 4-dimethylaminobenzoic acid and any combinations thereof. Particularly suited are 2-(4-chlorobenzoyl) benzoic acid, o-benzoylbenzoic acid, 2-(4-phenylbenzoyl)benzoic acid, benzoic acid, substituted benzoic acid, or any mixture thereof. Surprisingly it was found that both UV reactivity and adhesion improve therewith. Anhydrides thereof or suitable dialkylesters of any of the above (e.g. the dimethylesters and/or diethylesters) could eventually also be used.

Preferably the amount of mono-carboxylic compounds (X1), used to prepare the inert polyester (B2) is calculated to obtain a theoretical hydroxyl value between 120 and 0 mg KOH/g. Preferably the residual hydroxyl value of the polyester is at most 115 mg KOH/g, more preferably at most 80 mg KOH/g. Most preferably the residual hydroxyl value is at most 50 mg KOH/g. By "residual" is meant herein a value for hydroxyl groups that remain after reaction with the one or more mono-carboxylic compounds (X1).

Preferably the acid number of the second variant (B2) is at most 25 mg KOH/g, more preferably at most 15 mg KOH/g, more preferably at most 7 mg KOH/g.

According to a third variant of the invention, the composition comprises one or more inert polyesters (B1) according to the first variant and one or more inert polyesters (B2) according to the second variant.

Typically, based on the total weight of the inert polyesters (B), the weight percentage of inert polyesters (B1) of the first variant is between 0 and 100%, and the weight percentage of inert polyesters (B2) of the second variant is between 100 and 0%.

Inert polyesters (B) of the invention (according to any of the embodiments or variants) typically have a number average molecular weight (Mn) of between 500 and 5000 Daltons. Preferably the Mn is at least 500 Daltons, more preferably at least 750 Daltons. Preferably the Mn is at most 2500 Daltons, more preferably at most 2000 Daltons.

Inert polyesters (B) of the invention (according to any of the embodiments or variants) typically have a weight average molecular weight (Mw) of between 1000 and 10000 Daltons. Preferably the Mw is at least 1200 Daltons, more preferably at least 1500 Daltons. Preferably the Mw is at most 3500 Daltons, more preferably at most 3000 Daltons.

Molecular weights (Mn or Mw) typically are determined via gel permeation chromatography (GPC), typically using polystyrene standards. Most typically the Mn and Mw are measured by GPC (in a tetrahydrofuran (THF) solution, injected on a 3xPLgel 5µm Mixed-D LS 300x7.5mm column MW - range 162 to 377400 Daltons & calibrated with polystyrene standards (200-400.000 Daltons), at 40 °C).

Inert polyesters (B) of the invention (according to any of the embodiments or variants) typically have a glass transition temperature (Tg) of at least 5 °C, preferably at least 10 °C, more preferably at least 15 °C. Generally the Tg is at most 120°C, preferably at most 80 °C, more preferably at most 50 °C, as measured by dynamic scanning calorimetry (DSC) e.g. according to ASTM E1356-08 with a heating gradient of 10 degrees C per minute.

Based on the total amount of compounds (A) and (B), the amount of inert polyesters (B) in general is between 20 and 80% by weight (wt%). More typically this percentage is at least 30%, more preferably at least 40%. Generally their amount does not exceed 65%, more preferably it does not exceed 55 % by weight.

The compositions according to the invention may comprise other inert resins (C), which do not take part in the polymerisation reaction like the ones described in e.g. WO2002/38688,
WO2005/085369, WO2008/015474, WO2008/004002, EP1411077 & US5919834. By "other" is meant different from the inert polyester (B). Examples of such optional inert resins (C) typically include hydrocarbons (such as styrene based hydrocarbon resins), styrene allyl alcohols, acrylics (such as acrylic (co)polymers), (poly)urethane resins, polyethylenevinylacetate resins,
polyvinylchloride resins, chlorinated polyolefin resins and/or ketone resins. The total amount of such optional inert resins (C) or mixtures thereof does usually not exceed 50 % by weight,
preferably this amount does not exceed 30 % by weight, based on the total weight of inert resins (B) and (C).

In general the (binder) composition of the invention comprises from 20 to 80% by weight of compounds (A) and from 80 to 20 % by weight of inert resins (B) and, optionally (C). More in particular the (binder) composition of the invention comprises from 40 to 60 % by weight of compounds (A) and from 60 to 40 % by weight of inert resins (B) and, optionally (C).

In general the ethylenically unsaturated compound (A) comprises at least one (meth)acrylated compound. By "(meth)acrylated" is meant acrylated, methacrylated, or mixtures thereof. Preferably compounds (A) are acrylated compounds. The (meth)acrylated compounds used in the present invention can be in the form of monomers, oligomers or mixtures thereof. Preferred are those that are liquid at room temperature. Some examples of suitable compounds are given below.

Examples of (meth)acrylated oligomers (Ai) that can be used in the present invention include amino (meth)acrylate oligomers, polyester (meth)acrylates, (poly)urethane (meth)acrylates and epoxy (meth)acrylates. Once more the acrylated forms are preferred. Preferably the composition of the invention however comprises no (poly)urethane (meth)acrylate oligomers (Ai), more in particular comprises no (meth)acrylated oligomers (Ai). By (meth)acrylated oligomers (Ai) is meant to designate in particular (meth)acrylated compounds having a molecular weight MW higher than 5.000 Daltons.

Preferably the ethylenically unsaturated compound (A) is selected from one or more reactive diluents, which typically are monomers. Monomers used can be mono- and/or poly-functional (meth)acrylates (Aii). By "polyfunctional (meth)acrylates (Aii)" is meant compounds (Aii) that comprise at least two (meth)acryloyl groups. Particularly suited for use in the present invention are cardura (meth)acrylate (the (meth)acrylate of the glycidyl ester of neodecanoic acid also known as Cardura®E-10P), 3(4),8(9)-bis-(hydroxymethyl)-tricyclo-[5.2.1.0^{2,6}]decane di(meth)acrylate, 1,6-hexanediol di(meth)acrylate, dipropyleneglycol di(meth)acrylate, tripropyleneglycol di(meth)acrylate and/or trimethylolpropane tri(meth)acrylate. Also suitable are the di(meth)acrylates of a dianhydrohexitol, like for instance isosorbide di(meth)acrylate and in particular isosorbide diacrylate. Especially the acrylated forms thereof are used (of any of these). The inert resins [(B) and optionally (C)] typically are soluble in such diluting (meth)acrylate monomers in at least 20 wt%, more preferably at least 30 wt%.

Preferred diluting monomers (Aii) are di(meth)acrylates and/or tri(meth)acrylates like 1,6-hexanediol di(meth)acrylate, dipropyleneglycol di(meth)acrylate, 3(4),8(9)-bis-(hydroxymethyl)-tricyclo-[5.2.1.0^{2,6}]decane di(meth)acrylate, isosorbide di(meth)acrylate, tripropyleneglycol di(meth)acrylate and/or trimethylolpropane tri(meth)acrylate. Particularly preferred are 1,6-hexanediol di(meth)acrylate, dipropyleneglycol di(meth)acrylate, 3(4),8(9)-bis-(hydroxymethyl)-tricyclo-[5.2.1.0^{2,6}]decane di(meth)acrylate, tripropyleneglycol di(meth)acrylate and/or trimethylolpropane tri(meth)acrylate. Most preferred are di(meth)acrylates, more in particular diacrylates and in particular dipropyleneglycol diacrylate (DPGDA) and/or tripropyleneglycol diacrylate (TPGDA). Mono-functional and/or tetrafunctional (meth)acrylates can be used, but preferably they are used in an amount lower than 40% by weight, more preferably less than 20% by weight, based on the total amount of mono-and poly-functional monomers (Aii).

Preferably the ethylenically unsaturated compound (Aii) is for at least 80 wt% comprised of difunctional (meth)acrylates and/or tri(meth)acrylates, and for at most 20 wt% of mono-functional (meth)acrylates and/or tetra-functional (meth)acrylates. Most preferably the (meth)acrylated compound (Aii) contains no mono-functional (meth)acrylates.

The above diluting monomers (Aii) can, optionally, be further reacted with an amine to form an amino (meth)acrylate (Aiii) having residual free (meth)acrylate groups. By "residual free" is meant (meth)acrylate groups that remain after reaction with the amines. Preferred are amino (meth)acrylates with two or three (meth)acrylate groups per molecule after reaction with the amines. The (meth)acrylate group preferably is an acrylate group.

The amines used in this reaction are generally selected from primary amines and secondary amines. Generally preferred are primary amines comprising at least one primary amino group (-NH2) and/or secondary amines comprising at least two secondary amino groups (-NH) as described in WO 2008/000696 - see compounds A1&A2 therein. Process conditions as described therein can also be used here.

Amino (meth)acrylates (Aiii) can be added as such to the composition of the invention but may also be formed in situ by introducing the amine to the blend of inert polyesters ((B) and optionally (C)) and (meth)acrylated compounds (Aii), maintaining the reaction temperature typically at 60°C until the reaction is finished. The completion of the reaction can be followed for example by measuring the amount of free amine. For instance, amine contents can be determined by reacting quantatively the amines with CS2. The resulting thiocarbamic acid is potentiometrically titrated with NaOH. The amine content value is expressed in ppm. Examples of suitable amino (meth)acrylates (Aiii) include EBECRYL 7100, EBECRYL 80, EBECRYL 81, EBECRYL 83, EBECRYL 84, EBECRYL LEO 10551, EBECRYL LEO 10552 & EBECRYL LEO 10553, all available from Cytec.

The composition of the invention can, optionally, further comprise amine derivatives (D) obtained from the reaction between diluting monomers (Aii) as described above and amines, wherein the amine derivative obtained contains no residual free (meth)acrylate groups. Typically secondary amines A2 such as described in WO 2008/000696 are used in this reaction. Examples of suitable amine derivatives (D) are EBECRYL P115 and EBECRYL P116, available from Cytec.

Amino (meth)acrylates (Aiii) and amine derivatives (D) can act as photoactivators and enhance cure speed in the presence of type II photoinitiators, and benzophenone derivatives in particular. Based on the total amount of compounds (A), (B) and optionally (C), the total amount of ethylenically unsaturated compounds (A) in general is between 15 and 85% by weight. More typically this percentage is at least 25%, more preferably at least 35 %. Generally their amount does not exceed 75%, more preferably it does not exceed 65 % by weight.

Typically, on the total amount of compounds (A) the amount of diluting monomers (Aii plus Aiii) is between 20 and 100 % by weight. More typically this percentage is at least 50%, more preferably at least 80 %, generally it is 100%.

The optional amine derivatives (D) can replace up to 50 % by weight, typically up to 25% by weight of the total amount of ethylenically unsaturated compounds (A). When present, the amine derivatives (D) typically are used in an amount from 0.01 to 25% by weight, in general from 5 to 20% by weight, based on the total weight of the composition.

Viscosity of the binder, more in particular the blend composed of compounds (A), (B) and optionally (C), typically ranges from 100 to 10000 mPa.s at 25°C. Preferably the viscosity ranges from 200 to 5000 mPa.s. More preferably the viscosity ranges from 500 to 3000 mPa.s. as measured using a cone and plate type rheometer with a cone diameter of 25 mm and at an angle of 1° for the cone.

The compositions according to the invention can be prepared by any method suitable therefore. They are usually prepared by dissolving the inert resins (B) and optionally (C) in at least part of (meth)acrylated compounds (A) added, preferably at a temperature of at least 20 °C, more preferably of at least 30 °C, most preferably of at least 60 °C. The temperature preferably does not exceed 150 °C, more preferably it does not exceed 110 °C. The compositions according to the invention can be prepared in the presence of an organic solvent, which is thereafter eliminated from the composition, for example by stripping. More preferably, no solvents are used.

Other compounds can be added like pigments, dispersing agents or other additives, charges and photoinitiator. Often a photoinitiator and, optionally, a photoactivator are added.

Generally, the composition of the present invention comprises at least 10 % by weight, more preferably at least 15% by weight and most preferably at least 20% by weight of ethylenically unsaturated compounds (A), based on the total weight of the composition. The amount of such compounds (A) in the composition usually does not exceed 85% by weight, preferably does not exceed 75% and more preferably does not exceed 65% by weight.

Generally, the composition of the present invention comprises at least 10% by weight, more preferably at least 15% by weight and most preferably at least 20% by weight of the inert resins (B) and optionally (C), based on the total weight of the composition. The amount of inert resins (B) and optionally (C) in the composition usually does not exceed 85% by weight, preferably does not exceed 75% by weight, and more preferably does not exceed 65% by weight.

Typically the compositions of the invention comprise, based on the total weight of (A) and (B) and optionally (C), between 15% and 85% by weight of the compounds (A) and between 85% and 15% by weight of inert polyesters (B).

Typically the compositions of the invention are not water- or solvent-based compositions, and typically the amount of solvents (including water) in the compositions, if present at all, is at most 40 % by weight, in particular at most 25 % by weight, more in particular at most 20 % by weight, relative to the total weight of the composition.

An aspect of the invention relates to coating compositions, inks or varnishes comprising a composition, more in particular a binder composition according to the invention.

The compositions according to the invention after curing permit to obtain excellent adhesion on various organic and inorganic substrates such as plastic, metal, glass, wood, paper, in combination with high cure speed and low viscosity. In particular adhesion on plastic substrates like polypropylene, bioriented polypropylene, polyethylene, polyvinylchloride, polyester and polyamide films is good. Plastics can be of any type, e.g. the woven or non-woven type, can be non porous, permeable or semi-permeable etc. The plastic can be rigid but preferably is flexible. An advantage of the compositions of the invention is that they permit to obtain good adhesion on e.g. plastics without the need of an adhesion primer. The possibility to graft functional groups on the polyester resin can further improve adhesion and reactivity.

Pigment wetting is excellent which makes the compositions of the invention useful as ink vehicle for the preparation of inks, in particular inks for lithographic and flexographic applications. The compositions of the invention are particularly suited for printing onto a wide variety of rigid and flexible graphics, packaging and label substrates, as well as most plastics, glass and metal foil. The compositions of the invention are very suited for gravure, flexographic and lithographic applications. They are most suited as flexo inks for narrow, mid and wide web applications.

The composition of the present invention is therefore useful as ink vehicle for the preparation of inks. Typical ingredients used in the preparation of inks (paste or liquid) may thus be added. These compounds are generally selected from organic and inorganic pigments, photoinitiators, fillers and additives.

The pigments usable in the compositions of the invention are every pigments used in paste inks or liquid inks. A list of such pigments can be found in the Color Index. The pigments are preferably used at 0 to 60 % by weight of the total weight of the composition, more preferably at 1 to 50 % by weight.

The photoinitiators usable in the compositions of the invention are well known in the art. They can be chosen from α-hydroxyketones, α-aminoketones, benzildimethyl-ketals, acyl phosphines, benzophenone derivatives, thioxanthones and blends of these. They are typically used at 0 to 15% by weight. Generally, photoactivators are chosen between amine derivatives (D) and amino(meth)acrylates (Aiii) as discussed above such as EBECRYL P115, EBECRYL P116, EBECRYL 7100, EBECRYL 80, EBECRYL 81, EBECRYL 83, EBECRYL 84, EBECRYL LEO 10551, EBECRYL LEO 10552 & EBECRYL LEO 10553, all available from Cytec. In general photoinitiators and possibly also photoactivators are added if the compositions are cured by ultraviolet light. The compositions may however also be cured by electron beams rays, and, in this case, no photoinitiator and photoactivator needs to be added to the composition. In addition, advantageously no photoiniator needs to be added to the commposition when a moiety with photo initiating activity, more in particular a benzophenone derivative, is grafted onto the inert polyester of the invention (see inert polyesters B2 above). In such case, it may be advantageous to add photoactivators to the composition.

The additives are those commonly used in inks, such as stabilizers, substrate wetting agents, antifoam agents, dispersing agents, etc. The total amount of those additives does usually not exceed 5 % by weight of the total weight of the composition.

As fillers products such as calciumcarbonate, talc (magnesium silicate), kaolin clay (aluminium silicate), bariumsulphate, aluminium hydroxide, siliciumdioxide can be used. The amount of fillers is generally from 0 to 15% by weight of the total weight of the composition.

Preferably the composition according to the invention comprises, based on the total weight of the composition, from 20 to 70% by weight of the binder (composed of compounds (A), (B) and optionally (C)), from 20 to 50% by weight of pigments, and from 0 to 50% by weight of one or more usual ingredients selected from additives, fillers, photoinitiators and the like. Typically the compositions of the invention comprise, based on the total weight of the composition, at least 20% by weight of the binder, often at least 40% by weight of the binder.

An aspect of the invention relates to coating compositions and in particular inks and varnishes that comprise the binder composition as described above. Provided are inks and varnishes that are prepared from the binder compositions of the invention. The invention also relates to a process for the preparation of inks, in particular flexographic, litho inks and screen inks, wherein a binder composition according to the invention is used. More preferably, this invention relates to a process for the preparation of flexographic inks.

Flexographic inks are generally made in 2 steps, the pigment dispersion step and the letdown step. The composition according to the invention can be used in one or both of these steps. The composition according to the invention is preferably used as binder at least in the first step. In the first step, the pigments and optionally a photoinitiator, photoactivator, fillers and/or additives are added to at least part of the composition comprising the resin (B) and the optional resin (C) and (meth)acrylated compound (A). They are mixed and then dispersed on a triple roll or bead mill. A few passes might be necessary to achieve a good dispersion. Pigments that are difficult to disperse generally require more number of passes. The compositions according to the invention showing good pigment wetting, permit to limit the number of additional passes. Once the pigment has achieved this fineness, the pigment paste is further diluted with the letdown. This letdown is preferably composed of the same resin components (A), (B) and optionally (C). The letdown has to be compatible with the binder used to disperse the pigments.

The finished ink preferably has a viscosity higher than 300 mPa.s measured at a shear rate of 2500 s-1 at 25 °C (measured using a cone and plate type rheometer with a cone diameter of 25 mm and at an angle of 1° for the cone). The measurement is generally done by measuring a flow curve in controlled shear rate ranging from D = 0.1 s-1 to D = 2500 s-1 at 25 °C.

The finished ink preferably has a viscosity measured as here above of at least 500 mPa.s. The viscosity of the final generally does not exceed 8000 mPa.s, preferably it does not exceed 4000 mPa.s (at 25 °C and 2500 s-1).

The finished ink is then printed onto the substrate. The ink film can then be cured under a UV lamp, for example at 120W/cm and 50 m/min. A few passes may be required to cure the ink if the binder is not reactive enough.

The invention also relates to the polymeric compositions obtainable by curing the radiation curable composition as well as to substrates or articles being partially or entirely coated with the polymeric composition.

The invention also relates to a flexible graphic, more in particular a packaging or label substrate, that is printed with a composition (more in particular an ink) according to the invention. The packaging can be a food packaging such as a food packaging for indirect food contact.

Finally, the invention relates to a process for coating an article or a substrate comprising the step of applying onto at least one surface of said article or of said substrate the composition of the invention, following by curing of the applied layer. The composition of the invention can be directly applied onto said substrate or said article without the need of an adhesion primer. A physical treatment (e.g. corona) and/or chemical treatment before applying the radiation curable composition is preferred in some cases. The composition of the invention can be applied in one or more layers of between 0.5 and 10 µm by means of flexographic process, lithographic process, gravure, screen printing, letterpress, roller coater, curtain coater. Preferably, it is applied by flexographic process. The material or surface to be coated can comprise plastic, in particular can be made of plastic, including a non polar plastic. The plastic can be flexible or rigid. Further provided is also a method of improving adhesion of a radiation curable ink to a substrate in a printing process, said method comprising the step of applying a composition of the invention (more in particular an ink of the invention) to a surface of the substrate followed by a step of curing by radiation, typically ultraviolet radiation. The composition of the invention can be applied in one or more layers of between 0.5 and 10 µm by means of flexographic process, lithographic process, gravure, screen printing, letterpress, roller coater, curtain coater. Preferably, it is applied by a flexographic process. The material or surface to be coated can comprise plastic, in particular can be made of plastic, including a non polar plastic. The plastic can be flexible or rigid. An advantage of this process is that the composition of the invention can be applied directly onto the substrate. In other words, no primer layer needs to be applied first. Typically the substrate is a packaging or a label substrate for indirect food contact.

Throughout the invention and in particular in the Examples the following methods have been used to characterize the compositions of the invention:
Acid value: total acid number (IAc in mg KOH/g) were measured using potentiometric titration. The "total acid number" equals the milligrams of potassium hydroxide (KOH) required to neutralize the acid(s) present in 1g of sample after hydrolysis of present anhydrides. The anhydrides present in the sample are hydrolysed to the corresponding acids during a hydrolysis step and titrated with a standardized solution of KOH. Different titrant solutions i.e. KOH 0.1N and/or KOH 0.5N can be used when analyzing samples with low respectively high total acid number. Potentiometric titration allows end-point identification automatically by means of a titroprocessor and a pH electrode, the manual titration uses a color indicator (phenolphthalein) for visual end-point identification. The amount of KOH is used to calculate the total acid number.

Hydroxyl values (IOH in mg KOH/g) were measured using the following method. This "OH Number" method covers the automated quantification procedure for hydroxyl groups in polyester resins by means of potentiometric titration. The hydroxyl number is defined as the number of milligrams of potassium hydroxide required to neutralize the hydrolysis product of the fully acetylated derivative prepared out of one gram of polyester resin. Step 1 Acetylation step: All hydroxyl functions on the polyester resin are acetylated at room temperature by acetic anhydride in the presence of perchloric acid as catalyst. Dichloromethane (= methylenechloride CH2Cl2) functions as solvent. Step 2 Hydrolysis step: The excess of acetic anhydride is hydrolysed by means of water, N-methyl-2-pyrrolidone (NMP) functions as co solvent to dissolve water in methylene chloride and N-methylimidazole (NMI) functions as hydrolysis catalyst. Step 3 Titration step: The formed acid functions are titrated with KOH 0.5 N solution.

UV reactivity: a film of 1.2µm is applied on the tested BOPP (bioriented polypropylene), PET (polyethyleneterephtalate), polyester substrates without adhesion primer but with corona treatment and exposed to UV radiations from a 120 W/cm non focalized medium pressure mercury lamp at a defined conveyer speed (60 m/min) under air. For yellow, magenta and cyan inks: the fully cured aspect of the film is assessed by putting some graphite carbon black (Pencil Nr 2) onto the printed surface and rubbing with a finger and then with a cotton swab. As long as a black trace is left on the printed ink surface, the film is not fully cured and passed again under the UV-lamp. This is the so-called "graphite test". For black inks: the fully cured aspect of the film is assessed by putting some talc onto the printed surface and rubbing with a finger and then with a cotton. As long as a mat aspect is observed, the film is not fully cured. In both cases one assesses the number of times that the film has to pass at 60 m/min to obtain full curing (x passes at 60 m/min). The lower "x" is, the higher the cure speed.

Touch dry test: a film of 1.2µm is applied on the tested substrate and exposed to UV radiations from a 120 W/cm non focalized medium pressure mercury lamp at a defined conveyer speed (60 m/min). The fully cured aspect of the film is assessed by putting a thumb on the printed surface. As long as there is any imprint on the printed ink surface, the film is not fully cured and passed again under the UV-lamp. One notes the numbers of passes under the UV-lamp that is needed to have no imprint at all.

Adhesion: a film of 1.2µm is applied on the tested substrate and exposed to UV radiations from a 120W/cm non focalized medium pressure mercury lamp at a speed of 60 m/min and fully cured as described in the reactivity method. A string of adhesive tape (Tesa 4104) is pressed on the surface and the interlayer is degassed. The tape is then snatched off. Based on the % of the surface removed by the tape, a value of adhesion is given: 100 (0% of the surface removed), 80 (20% of the surface removed), 0 (100% of the surface removed).

Pigment wetting properties of the resin is evaluated during different stages: during pigment paste preparation stage and after curing.

During pigment paste preparation phase the pigment wetting is evaluated in the following way: For the present invention the pigment wetting is rated on a scale from 5 = excellent to 0 = bad pigment wetting. To assess pigment wetting the weight of the binder (blend of compounds (A), (B) and optionally (C)) and of the pigment that will be put on top of the binder are first determined, and then both are mixed by hand. Then the easiness of mixing (wetting) the pigment with the binder is determined. When a homogeneous paste is obtained, it is grinded on a three roller mill (2x at 12 bar) and the behavior on the rolls is being checked. In case of a bad pigment wetting, dry pigment can be found on the rolls. The dispersion rate on the grinding gauge is checked as confirmation of bad wetting. With the grinding gauge the thickness of the pigment particles is measured. The smaller the size of the particles, the better is the pigment wetting. The high gloss of the paste on the rolls is also an indication of good pigment wetting.

Pigment wetting after curing is evaluated by measuring the optical density (after this step). Optical density: The color density of the printed ink at constant film thickness is measured. In this case the ink is printed using a lab applicator and the color density is measured with a densitometer, which spectrophotometrically compares the reflected light to the incident light. Here, a Gretag Macbeth Spectroeye Spectrophotometer / Densitometer equipped with the appropriate filters was used to measure optical density. Film thickness (in g/m²) is determined by comparing the weight of the printed form or substrate before and after printing.

Rheology (yield value, viscosity, shortness index): is measured using a cone and plate type rheometer MCR100 (Paar-Physica) following ISO 3219. The measurement geometry for measuring the (flexo) inks of the inventions was of a diameter of 25mm and an angle of 1° for the cone. The measurement was a flow curve in controlled shear rate ranging from D = 0 s-1 (zero viscosity), D = 2.5 s-1 to D = 2500 s-1 at 25 °C.

Viscosity of the resin: is measured at a fixed shear rate with a cone and plate type rheometer MCR100 (Paar-Physica).Transition temperatures (Tg) were measured by DSC following ASTM E1356-08.

Molecular weight distribution was measured by gel permeation chromatography (GPC). It was determined with 3 x PLgel 5µm Mixed-D LS 300 x 7.5mm separation columns, polystyrenes calibration (MW range : 200 - 400.000 Daltons), TetrahydroFuran (THF) as solvent and Refractive Index as detector.

The invention will now be illustrated by the following non-limiting examples which are by way of illustration only. Unless otherwise indicated, all the test results and properties herein were performed using conventional methods well known to those skilled in the art. The amounts in the tables are given in % by weight based on the total weight of the composition.

### Preparative examples:

### Example 1: OH-terminated polyester based on ethyleneglycol EG and phthalic anhydride (PA)

A 5 liter reactor equipped with a stirrer and a column is charged with 343 g of ethylene glycol (EG), 722 g of phthalic anhydride (PA), and 2.7 g of a tin catalyst. The mass was heated to 160°C under atmospheric pressure and nitrogen flow. When the partial acid value was in the same range of the total acid value, the mass was heated to 220°C. When no water distilled anymore, vacuum was applied. The reaction mixture was heated until the acid value was lower than 10 mg KOH/g. Ethylene glycol was added in order to reach an hydroxyl value of 65-80 mg KOH/g. Mn = 1480; Mw = 2720 as measured by GPC.

### Example 2: OH terminated polyester based on EG, PA and neopentylglycol (NPG)

A 5 liter reactor equipped with a stirrer and a column was charged with 155 g of ethylene glycol (EG), 2022 g of phthalic anhydride (PA), 1390 g of neopentylglycol (NPG) and 2.3 g of a tin catalyst. The mass was heated to 160°C under atmospheric pressure and nitrogen flow. When the partial acid value was in the same range of the total acid value, the mass was heated to 220°C. When no water distilled anymore, vacuum was applied. The reaction mixture was heated until the acid value was lower than 10 mg KOH/g. Ethyleneglycol was added (57 g) in order to get an hydroxyl value of 85-95 mg KOH/g. Mn = 1540 Mw = 2910 as measured by GPC.

### Example 3: Polyester based on EG and PA, modified with 2-(4-chlorobenzoyl) benzoic acid

1494 g of the polyester from example 1 is further reacted with 464 g of 2-(4-chlorobenzoyl) benzoic acid until both the acid and hydroxyl values are lower than 10 mg KOH/g.

### Example 4: Polyester based on EG and PA, modified with benzoylbenzoic acid

1500 g of the polyester from example 1 is further reacted with 485 g of 2-benzoylbenzoic acid until the acid and hydroxyl values are lower than 10 mg KOH/g.

### Example 5: Polyester based on EG, NPG and PA, modified with 2-(4-chlorobenzoyl) benzoic acid

A 5 liter reactor equipped with a stirrer and a column was charged with 92 g of ethylene glycol (EG), 1228 g of phthalic anhydride (PA), 829 g of neopentylglycol (NPG), 352 g of 2-(4-chlorobenzoyl) benzoic acid and 1.9 g of a tin catalyst. The mass was heated to 160°C under atmospheric pressure and nitrogen flow. When the partial acid value was in the same range of the total acid value, the mass was heated to 220°C. When no water distilled anymore, vacuum was applied. The reaction mixture was heated until the acid value was lower than 10 mg KOH/g. Ethyleneglycol was added in order to get hydroxyl value of 22-26 mg KOH/g.

### Example 6: Polyester based on EG, NPG and PA, modified with benzoic acid

A 5 liter reactor equipped with a stirrer and a column was charged with 115g of ethylene glycol (EG), 1535 g of phthalic anhydride (PA), 1037 g of neopentylglycol (NPG), 218 g of benzoic acid and 2.2 g of a tin catalyst. The mass was heated to 160°C under atmospheric pressure and nitrogen flow. When the partial acid value was in the same range of the total acid value, the mass was heated to 220°C. When no water distilled anymore, vacuum was applied. The reaction mixture was heated until the acid value was lower than 10 mg KOH/g. Ethyleneglycol was added in order to get hydroxyl value of 26-30 mg KOH/g. Mn = 1470 Mw = 2730 as measured by GPC.

### Example 7: Polyester based on EG, ISO, PA, modified with 2-(4-chlorobenzoyl) benzoic acid

A 5 liter reactor equipped with a stirrer and a column was charged with 239 g of ethylene glycol (EG), 835 g of phthalic anhydride (PA), 470 g of isosorbide (ISO) (80 wt% in water), 318 g of 2-(4-chlorobenzoyl) benzoic acid and 1.4 g of a tin catalyst. The mass was heated to 160°C under atmospheric pressure and nitrogen flow. When the partial acid value was in the same range of the total acid value, the mass was heated to 220°C. When no water distilled anymore, vacuum was applied. The reaction mixture was heated until the acid value was lower than 10 mg KOH/g. The hydroxyl value was 47 mg KOH/g. Mn = 990 Mw = 1560 as measured by GPC.

### Example 8R: COOH-terminated polyester based on EG, PA, NPG, modified with benzoic acid

A 5 liter reactor equipped with a stirrer and a column was charged with 62g of ethylene glycol (EG), 1674 g of phthalic anhydride (PA), 200 g of neopentylglycol (NPG), 307 g of benzoic acid and 1.9 g of a tin catalyst. The mass was heated to 160°C under atmospheric pressure and nitrogen flow. When the partial acid value was in the same range of the total acid value, the mass was heated to 220°C. When no water distilled anymore, vacuum was applied. The reaction mixture was heated until the acid value was in the range of 50 mg KOH/g. Hydroxyl value was in the range of 14-18 mg KOH/g. Mn = 898 Mw = 1560 as measured by GPC.

### Example 9R: OH-terminated Polyester based on PA and NPG (without EG)

A 5 liter reactor equipped with a stirrer and a column was charged with 1531 g of phthalic anhydride (PA), 1255 g of neopentylglycol (NPG) and 2.1 g of a tin catalyst. The mass was heated to 160°C under atmospheric pressure and nitrogen flow. When the partial acid value was in the same range of the total acid value, the mass was heated to 220°C. When no water distilled anymore, vacuum was applied. The reaction mixture was heated until the acid value was in the range of 60 mg KOH/g.

### Formulation examples:

Binder compositions were prepared by dissolving the inert resins (B) at 70 to 90 °C in the acrylated compounds (A) according to the ratios (in g) as indicated in the Table1 below. Viscosity of the resin was determined at a shear rate of zero, 2.5 and 2500 s-1 at 25°C as indicated above. EBECRYL® 450 is a commercially available polyester acrylate from Cytec and served as reference (Ref).

The pigment paste was prepared as follows: 66 wt % of the binder was mixed with 30 wt % of pigments and 4 wt % of additives. In particular 65.7 g of the binder was blended at 25 °C with 1 g of ADDITOL® S120 (a stabilizer blend from Cytec), 2.5 g of SOLSPERSE® 39000 (a 100% active polymeric dispersant from Lubrizol), 0.8 g of SOLSPERSE® 5000 (a 100% active pigmentary synergist from Lubrizol) and 30 g of GLO pigment (Copper Phthalocyanine - Irgalite GLO of Ciba).
The paste was grinded on triple rolls until the right grinding gauge was obtained.

The ink was prepared from this pigment paste by diluting further with the resin binder, photoinitiator and diluting monomers to achieve the target viscosity. In particular cyan inks (at 14% pigment) were prepared by blending at 25 °C 43 g of the binder with 10 g of a photoinitiator mix (composition: 30% ITX (isopropylthioxanthone); 25% Additol EPD from Cytec; 25% Additol EHA from Cytec; 5% Additol PBZ from Cytec; 15% Irgacure 369 from BASF) and 47 g of the Pigment paste at 30%.

Various properties of the obtained ink formulations were measured. These are summarized in Tables 1, 2 and 3 below. These tables show that the compositions according to the present invention permit to obtain inks having excellent adhesion on plastics and this without the need for an adhesion primer. The inks of Examples 1&3 exhibited a higher UV reactivity and an excellent adhesion on BOPP substrates compared to the control (EBECRYL® 450, Ref). Modification with a mono-carboxylic compound increased to some extent UV reactivity but surprisingly also improved adhesion on some of the substrates such as BOPP and polyester substrates (Example 4) - Table 1. The presence of neopentylglycol units in the polyester backbone had a clear positive influence on adhesion on e.g. Melinex and RNK substrates and gave excellent pigment wetting (Examples 3, 5&5-BIS). Inks prepared from a COOH-terminated polyester (Example 8R), even when based on the same glycols and diacids, resulted in a poor adhesion and pigment wetting compared to inks according to the invention - Table 2. OH-terminated polyesters that do not contain any ethylene glycol were not suitable (Example 9R). This polyester diluted in monomer was incompatible after a few hours - results not shown.

In conclusion: the overall balance of properties improved when using compositions according to the invention. In particular the balance between adhesion reactivity and pigment wetting was found excellent.

**Table 1: Ink properties and adhesion**

| Product | | Ref | F1 | | | | F3 | | | | F4 | |
|---|---|---|---|---|---|---|---|---|---|---|---|---|
| Polyols/polycarboxy | | - | EG-PA | | | | EG-PA | | | | EG-PA | |
| Modification | | - | - | | | | Cl-AOBB | | | | BBA | |
| Polyester (B) | | - | Ex1 | | | | Ex3 | | | | Ex4 | |
| Tests↓ Monomers (A)→ | | - | DPGDA | TMPTA | | | DPGDA | TMPTA | | | DPGDA | TPGDA |
| Polyester/monomer | | - | 50/50 | 50/50 | | | 50/50 | 50/50 | | | 50/50 | 50/50 |
| Zero visco | | 1760 | 60900 | 156000 | | | 23600 | 113000 | | | 72000 | 22800 |
| 2.5 s-1 | | 1380 | 6530 | 45000 | | | 4430 | 43400 | | | 12500 | 6900 |
| 2500 s-1 | | 836 | 1960 | 18900 | | | 1210 | 27100 | | | 2570 | 2730 |
| Graphite | | 4x | 2x | 2x | | | 1x | 1x | | | 2x | 2x |
| Touch dry | | 3x | 1x | 1x | | | 1x | 1x | | | 2x | 2x |
| Adhesion C58 | BOPP | 10 | 90 | 90 | | | 100 | 100 | | | 85 | 90 |
| GND | BOPP | 0 | 100 | 100 | | | 100 | 100 | | | 95 | 95 |
| NND | BOPP | 0 | 100 | 100 | | | 100 | 100 | | | 90 | 90 |
| Melinex | PET | 0 | 0 | 0 | | | 40 | 10 | | | 0 | 0 |
| RNK | PET | 0 | 0 | 0 | | | 0 | 0 | | | 30 | 30 |
| Mylar | PET | 0 | 50 | 100 | | | 20 | 50 | | | 100 | 100 |
| BX | P.A | 0 | 0 | 0 | | | 0 | 0 | | | 0 | 0 |
| Density | | 1.52 | low | low | | | 1.6 | 1.07 | | | 1.29 | 1.25 |

| | | | | | | | | | | | | |
|---|---|---|---|---|---|---|---|---|---|---|---|---|
| C58:BOPP without adhesion primer; GND:BOPP without adhesion primer; NND:BOPP without adhesion primer; Melinex: polyester without adhesion primer; Mylar: polyester without adhesion primer; BX: polyamide without adhesion primer; BOPP: Bioriented polypropylene; DPGDA:dipropyleneglycoldiacrylate; TPGDA: tripropyleneglycoldiacrylate; TMPTA: trimethylolpropanetriacrylate; Cl-AOBB:2-(4-chlorobenzoyl) benzoic acid; RNK: PET substrate without adhesion primer; PET: polyethylene terephthalate; P.A: polyamide; PE: polyester; BBA: benzoyl benzoic acid; BA: benzoic acid. | | | | | | | | | | | | |

**Table 2: Ink properties and adhesion**

| Product | | Ref | F1 | | F2 | F3 | | F4 | | F5 | F6 | F5-BIS | F8R/ COOH |
|---|---|---|---|---|---|---|---|---|---|---|---|---|---|
| Polyols/Polycarboxy | | - | EG-PA | | EG-PA-NPG | EG-PA | | EG-PA | | EG-NPG-PA | EG-NPG-PA | EG-NPG-PA | EG-NPG-PA |
| Modification | | - | - | | | Cl-AOBB | | BBA | | Cl-AOBB | BBA | Cl-AOBB | BA |
| Polyester (B) | | - | Ex1 | | Ex2 | Ex3 | | Ex4 | | Ex5 | Ex6 | Ex5 | Ex7R |
| Tests↓ Monomers (A)→ | | - | DPGDA | TMPTA | TPGDA | DPGDA | TMPTA | DPGDA | TPGDA | TPGDA | TPGDA | TPGDA | TPGDA |
| Polyester/monomer | | - | 50/50 | 50/50 | 50/50 | 50/50 | 50/50 | 50/50 | 50/50 | 50/50 | 50/50 | 50/50* | 50/52 |
| Zero visco | | 1760 | 60900 | 156000 | 17000 | 23600 | 113000 | 72000 | 22800 | 25000 | 19000 | 46300 | 263000 |
| 2.5 s-1 | | 1380 | 6530 | 45000 | 8680 | 4430 | 43400 | 12500 | 6900 | 6610 | 5780 | 8870 | 12400 |
| 2500 s-1 | | 836 | 1960 | 18900 | 3520 | 1210 | 27100 | 2570 | 2730 | 2290 | 1940 | 2960 | 2160 |
| Graphite | | 4x | 2x | 2x | 3x | 1x | 1x | 2x | 2x | 2x | 3x | 4x | 3x |
| Touch dry | | 3x | 1x | 1x | 3x | 1x | 1x | 2x | 2x | 2x | 3x | 4x | 3x |
| Adhesion C58 | BOPP | 10 | 90 | 90 | 100 | 100 | 100 | 85 | 90 | 85 | 90 | | 35 |
| GND | BOPP | 0 | 100 | 100 | 100 | 100 | 100 | 95 | 95 | 100 | 20 | 100 | 100 |
| NND | BOPP | 0 | 100 | 100 | 90 | 100 | 100 | 90 | 90 | 80 | 100 | 80 | 25 |
| Melinex | PE | 0 | 0 | 0 | 70 | 40 | 10 | 0 | 0 | 20 | 80 | 100 | 35 |
| RNK | PET | 0 | 0 | 0 | 40 | 0 | 0 | 30 | 30 | 20 | 10 | 30 | 20 |
| Mylar | PE | 0 | 50 | 100 | | 20 | 50 | 100 | 100 | | | | |
| BX | PA | 0 | 0 | 0 | | 0 | 0 | 0 | 0 | | | | |
| Density | | 1.52 | low | low | 1.51 | 1.60 | 1.07 | 1.29 | 1.25 | 1.67 | 1.70 | 1.45 | 1.37 |
| Pigment wetting | | 5 | 4 | | 4 | 5 | | 4 | | 5 | 4 | 5 | 2 |

| | | | | | | | | | | | | | |
|---|---|---|---|---|---|---|---|---|---|---|---|---|---|
| * 20% of the monomer (A) is replaced by EBECRYL P116 from Cytec so that of the 50 parts monomer 40 parts are TPGDA and 10 parts are EBECRYL P116 | | | | | | | | | | | | | |

**Table 3: Ink properties and adhesion**

| Product | | Ref | F7 |
|---|---|---|---|
| Polyols/Polycarboxy | | - | EG-ISO-PA |
| Modification | | - | Cl-AOBB |
| Polyester (B) | | - | Ex 7 |
| Tests↓ | | | |
| Monomers (A)→ | | - | TPGDA |
| | | | |
| Polyester/monomer | | - | 50/50 |
| Zero visco | | 1760 | 66800 |
| 2.5 s-1 | | 1380 | 10900 |
| 2500 s-1 | | 836 | 3210 |
| Graphite | | 4 x | 2x |
| Touch dry | | 3 x | 2x |
| Adhesion C58 | BOPP | 10 | 100 |
| GND | BOPP | 0 | 100 |
| NND | BOPP | 0 | 75 |
| Melinex | PE | 0 | 20 |
| RNK | PET | 0 | 80 |
| Mylar | PE | 0 | |
| BX | PA | 0 | |
| Density | | 1.52 | 1.51 |
| Pigment wetting | | 5 | 4 |

## Claims

1. A radiation curable composition comprising at least one ethylenically unsaturated compound (A) and at least one inert OH-terminated polyester (B) prepared from a polyol component that comprises ethylene glycol, and from a polycarboxy component that comprises phthalic acid and/or phthalic anhydride or that comprises one or more dialkylesters of phthalic acid;
wherein the inert polyester (B) has a total equivalent ratio of hydroxyl groups from the polyols to carboxyl groups from the polycarboxylic acids that exceeds 1.0 so that the said inert polyester (B) has free hydroxyl groups on the ends of the polymer backbone; and
wherein the inert polyester (B) has 0.1 or fewer equivalents of radiation curable reactive groups per kilogram.

2. The composition of claim 1 wherein the said curable reactive groups are selected from (meth)acrylic groups and/or vinyl groups.

3. The composition of claim 1 or 2 wherein the polyol component comprises from 10 to 100 mole% of ethylene glycol and from 0 to 90 mole % of other polyols, and wherein the polycarboxy component comprises from 80 to 100 mole% of phthalic acid and/or phthalic anhydride.

4. The composition of claim 3 wherein the inert polyester is further prepared from 0 to 20 mole% of other suitable polycarboxylic acids that are selected from saturated polycarboxylic acids.

5. The composition of any of the preceding claims, wherein the polyester is prepared from phthalic anhydride, from ethylene glycol and, optionally, from neopentyl glycol and/or isosorbide.

6. The composition of any of the preceding claims, wherein the hydroxyl value of the inert polyester is between 50 and 120 mg KOH/g.

7. The composition of any of the preceding claims, wherein the inert polyester is further prepared from one or more mono-carboxylic compounds.

8. The composition of claim 7, wherein the mono-carboxylic compound is selected from one or more of 2-(4-chlorobenzoyl) benzoic acid, o-benzoylbenzoic acid, 2-(4-phenylbenzoyl)benzoic acid, benzoic acid and substituted benzoic acid.

9. The composition of any of claims 7-8, wherein the hydroxyl value of the inert polyester is between 0 and 120 mg KOH/g.

10. The composition of any of the preceding claims, comprising at least one inert polyester as recited in any of claims 1 to 4 and at least one inert polyester as recited in any of claims 7 to 8.

11. The composition of any of the preceding claims, wherein the inert polyester (B) has a number average molecular weight of between 500 and 5000 Daltons.

12. The composition of any of the preceding claims, wherein the ethylenically unsaturated compound (A) comprises at least one (meth)acrylated compound selected from di(meth)acrylates and/or tri(meth)acrylates.

13. The composition of any of the preceding claims comprising at least 10% by weight of inert resins.

14. The composition of any of the preceding claims, further comprising a photoinitiator and, optionally a photoactivator.

15. A coating composition, ink or varnish comprising a composition according to any of the claims 1 to 14.

16. An article coated, partially or entirely, with a composition according to claim 15.

## Patentansprüche

1. Strahlungshärtbare Zusammensetzung, umfassend mindestens eine ethylenisch ungesättigte Verbindung (A) und mindestens einen inerten OHterminierten Polyester (B), hergestellt aus einer Polyolkomponente, die Ethylenglykol umfasst, und einer Polycarboxykomponente, die Phthalsäure und/oder Phthalsäureanhydrid umfasst oder die einen oder mehrere Dialkylester von Phthalsäure umfasst;
wobei der inerte Polyester (B) ein Gesamtäquivalentverhältnis von Hydroxylgruppen aus den Polyolen zu Carboxylgruppen aus den Polycarbonsäuren von mehr als 1,0 aufweist, so dass der inerte Polyester (B) freie Hydroxylgruppen an den Enden der Polymerhauptkette aufweist; und
wobei der inerte Polyester (B) 0,1 oder weniger Äquivalente strahlungshärtbarer reaktiver Gruppen pro Kilogramm aufweist.

2. Zusammensetzung nach Anspruch 1, wobei die härtbaren reaktiven Gruppen aus (Meth)acrylgruppen und/oder Vinylgruppen ausgewählt sind.

3. Zusammensetzung nach Anspruch 1 oder 2, wobei die Polyolkomponente 10 bis 100 Mol-% Ethylenglykol und 0 bis 90 Mol-% anderer Polyole umfasst und wobei die Polycarboxykomponente 80 bis 100 Mol-% Phthalsäure und/oder Phthalsäureanhydrid umfasst.

4. Zusammensetzung nach Anspruch 3, wobei der inerte Polyester ferner aus 0 bis 20 Mol-% anderer geeigneter Polycarbonsäuren, die aus gesättigten Polycarbonsäuren ausgewählt sind, hergestellt wird.

5. Zusammensetzung nach einem der vorhergehenden Ansprüche, wobei der Polyester aus Phthalsäureanhydrid, Ethylenglykol und gegebenenfalls Neopentylglykol und/oder Isosorbid hergestellt wird.

6. Zusammensetzung nach einem der vorhergehenden Ansprüche, wobei die Hydroxylzahl des inerten Polyesters zwischen 50 und 120 mg KOH/g liegt.

7. Zusammensetzung nach einem der vorhergehenden Ansprüche, wobei der inerte Polyester ferner aus einer oder mehreren Monocarboxylverbindungen hergestellt wird.

8. Zusammensetzung nach Anspruch 7, wobei die Monocarboxylverbindung aus 2-(4-Chlorbenzoyl)benzoesäure, o-Benzoylbenzoesäure, 2-(4-Phenylbenzoyl)-benzoesäure, Benzoesäure und/oder substituierter Benzoesäure ausgewählt ist.

9. Zusammensetzung nach einem der Ansprüche 7-8, wobei die Hydroxylzahl des inerten Polyesters zwischen 0 und 120 mg KOH/g liegt.

10. Zusammensetzung nach einem der vorhergehenden Ansprüche, umfassend mindestens einen inerten Polyester gemäß einem der Ansprüche 1 bis 4 und mindestens einen inerten Polyester gemäß einem der Ansprüche 7 bis 8.

11. Zusammensetzung nach einem der vorhergehenden Ansprüche, wobei der inerte Polyester (B) ein zahlenmittleres Molekulargewicht zwischen 500 und 5000 Dalton aufweist.

12. Zusammensetzung nach einem der vorhergehenden Ansprüche, wobei die ethylenisch ungesättigte Verbindung (A) mindestens eine (meth)acrylierte Verbindung, die aus Di(meth)acrylaten und/oder Tri(meth)acrylaten ausgewählt ist, umfasst.

13. Zusammensetzung nach einem der vorhergehenden Ansprüche, die mindestens 10 Gew.-% inerte Harze umfasst.

14. Zusammensetzung nach einem der vorhergehenden Ansprüche, die ferner einen Photoinitiator und gegebenenfalls einen Photoaktivator umfasst.

15. Beschichtungszusammensetzung, Tinte oder Lack, umfassend eine Zusammensetzung nach einem der Ansprüche 1 bis 14.

16. Artikel, der ganz oder teilweise mit einer Zusammensetzung nach Anspruch 15 beschichtet ist.

## Revendications

1. Composition durcissable par rayonnement comprenant au moins un composé à insaturation éthylénique (A) et au moins un polyester à terminaison OH inerte (B) préparé à partir d'un composant polyol qui comprend de l'éthylèneglycol et à partir d'un composant polycarboxy qui comprend de l'acide phtalique et/ou de l'anhydride phtalique ou qui comprend un ou plusieurs esters dialkyliques de l'acide phtalique ; dans laquelle le polyester inerte (B) a un rapport des équivalents totaux des groupes hydroxyle provenant des polyols aux groupes carboxyle provenant des acides polycarboxyliques qui est supérieur à 1,0 de sorte que ledit polyester inerte (B) a des groupes hydroxyle libres sur les extrémités du squelette du polymère ; et dans laquelle le polyester inerte (B) a 0,1 ou moins de 0,1 équivalent de groupes réactifs durcissables par rayonnement par kilogramme.

2. Composition selon la revendication 1 dans laquelle lesdits groupes réactifs durcissables sont choisis parmi les groupes (méth)acryliques et/ou les groupes vinyliques.

3. Composition selon la revendication 1 ou 2 dans laquelle le composant polyol comprend de 10 à 100 % en mole d'éthylèneglycol et de 0 à 90 % en mole d'autres polyols et dans laquelle le composant polycarboxy comprend de 80 à 100 % en mole d'acide phtalique et/ou d'anhydride phtalique.

4. Composition selon la revendication 3 dans laquelle le polyester inerte est en outre préparé à partir de 0 à 20 % en mole d'autres acides polycarboxyliques appropriés qui sont choisis parmi les acides polycarboxyliques saturés.

5. Composition selon l'une quelconque des revendications précédentes, dans laquelle le polyester est préparé à partir d'anhydride phtalique, à partir d'éthylèneglycol et, éventuellement, à partir de néopentylglycol et/ou d'isosorbide.

6. Composition selon l'une quelconque des revendications précédentes, dans laquelle l'indice d'hydroxyle du polyester inerte est compris entre 50 et 120 mg de KOH/g.

7. Composition selon l'une quelconque des revendications précédentes, dans laquelle le polyester inerte est en outre préparé à partir d'un ou plusieurs composés monocarboxyliques.

8. Composition selon la revendication 7, dans laquelle le composé monocarboxylique est choisi parmi un ou plusieurs de l'acide 2-(4-chlorobenzoyl)benzoïque, de l'acide o-benzoylbenzoïque, de l'acide 2-(4-phénylbenzoyl)benzoïque, de l'acide benzoïque et de l'acide benzoïque substitué.

9. Composition selon l'une quelconque des revendications 7-8, dans laquelle l'indice d'hydroxyle du polyester inerte est compris entre 0 et 120 mg de KOH/g.

10. Composition selon l'une quelconque des revendications précédentes, comprenant au moins un polyester inerte tel que cité dans l'une quelconque des revendications 1 à 4 et au moins un polyester inerte tel que cité dans l'une quelconque des revendications 7 à 8.

11. Composition selon l'une quelconque des revendications précédentes, dans laquelle le polyester inerte (B) a une masse moléculaire moyenne en nombre comprise entre 500 et 5000 Daltons.

12. Composition selon l'une quelconque des revendications précédentes, dans laquelle le composé à insaturation éthylénique (A) comprend au moins un composé (méth)acrylé choisi parmi les di(méth)acrylates et/ou les tri(méth)acrylates.

13. Composition selon l'une quelconque des revendications précédentes comprenant au moins 10 % en poids de résines inertes.

14. Composition selon l'une quelconque des revendications précédentes, comprenant en outre un photoinitiateur et, éventuellement, un photoactivateur.

15. Composition de revêtement, encre ou vernis comprenant une composition selon l'une quelconque des revendications 1 à 14.

16. Article revêtu, partiellement ou entièrement, d'une composition selon la revendication 15.
